**Europäisches Patentamt**

**European Patent Office**

**Office européen des brevets**

(11) Veröffentlichungsnummer : **0 016 925**
**B1**

# (12) EUROPÄISCHE PATENTSCHRIFT

(45) Veröffentlichungstag der Patentschrift :
01.09.82

(21) Anmeldenummer : 80100495.3

(22) Anmeldetag : 01.02.80

(51) Int. Cl.³ : **H 05 K  3/24**, H 01 L 21/00,
H 01 L 21/308, H 01 L 21/88

(54) Verfahren zum Aufbringen von Metall auf Metallmuster auf dielektrischen Substraten.

(30) Priorität : 28.02.79 US 16033

(43) Veröffentlichungstag der Anmeldung :
15.10.80 (Patentblatt 80/21)

(45) Bekanntmachung des Hinweises auf die Patenterteilung : 01.09.82 Patentblatt 82/35

(84) Benannte Vertragsstaaten :
DE FR GB

(56) Entgegenhaltungen :
DE A 2 040 180
DE A 2 723 499

(73) Patentinhaber : International Business Machines Corporation
Armonk, N.Y. 10504 (US)

(72) Erfinder : Schmeckenbecher, Arnold Friedrich
228 Wilbur Boulevard
Poughkeepsie, New York (US)

(74) Vertreter : Oechssler, Dietrich, Dr.rer.nat. Dipl.-Chem.
Schönaicher Strasse 220
D-7030 Böblingen (DE)

Imprimerie Jouve, 18, rue St-Denis, 75001 Paris, France

## Verfahren zum Aufbringen von Metall auf Metallmuster auf dielektrischen Substraten

Die Erfindung betrifft ein Verfahren zum Aufbringen von Metall auf Metallmuster, welche auf einem dielektrischen Substrat aufliegen.

Die Technik der Herstellung vielschichtiger Keramiksubstrate, welche als Unterlage für Halbleiterchips dienen und welche auch elektrische Verbindungen zu den Halbleiterchips bereitstellen, ist relativ gut bekannt. Zur Herstellung solcher Substrate wird zunächst ein Brei aus einem geeigneten Keramikpulver, einem harzartigen Bindemittel, einem Lösungsmittel für das Bindemittel und im allgemeinen einem Weichmacher hergestellt. Dieser Brei wird dann mit einem Abstreifmesser auf eine Unterlage aufgebracht und anschließend getrocknet, wobei dünne flexible Platten entstehen, welche normalerweise als grüne Keramikplatten bezeichnet werden. In diese Platten werden Durchführungslöcher gestanzt, die mit einer leitfähigen Paste gefüllt werden, und außerdem werden aus dieser Paste auf den Platten Leitermuster erzeugt. Diese bilden zusammen mit dem leitfähigen Material in den Durchführungslöchern schlußendlich das interne « Verdrahtungs »-System in dem Substrat. Die gestanzten und bedruckten grünen Platten werden zu einem Substrat laminiert, welches oft aus 15 bis 30 Platten besteht, und anschließend wird das Laminat gesintert. Auf dem resultierenden Substrat können viele Bauteile befestigt werden, welche untereinander über die interne « Verdrahtung » verbunden sind. Kontakte nach außen werden über eine Vielzahl von Eingangs- und Ausgangsstiften hergestellt, welche sich auf der den Bauteilen entgegengesetzten Seite des Substrats befinden. Es ist wünschenswert, daß das Vielschicht-Keramiksubstrat in der Weise hergestellt wird, daß die Leiterzüge und Durchführungslöcher sehr kleine Dimensionen aufweisen. Eine solche Mikrominiaturisierung ist wünschenswert, damit die Abmessungen der Verdrahtung mit den Abmessungen der Chips mit integrierten Schaltungen, welche auf dem Substrat befestigt sind, kompatibel sind. Das Substrat muß auf seiner oberen Oberfläche mit vielen, sehr kleinen, Anschlußpunkten (pads) versehen werden, welche in der Lage sind, mit entsprechenden, nahe beieinanderstehenden Anschlußpunkten auf den Chips elektrischen Kontakt zu machen. Um einen möglichst effektiven Gebrauch der modernen integrierten Schaltungstechnologie zu machen, werden möglichst viele Halbleiterchips auf demselben Substrat befestigt, und das Substrat muß dann auch die notwendigen elektrischen Verbindungen zur Verfügung stellen. Eine solche Anordnung hält den Abstand zwischen untereinander verbundenen Bauteilen klein, und dadurch wird die Zeit, welche ein Signal benötigt, um zwischen untereinander zusammenhängenden Bauteilen hin und her zu wandern, auf ein Minimum reduziert. Darüber hinaus reduziert eine solche Anordnung die Anzahl von elektrischen Verbindungen, welche gemacht werden müssen, wodurch sich die Kosten verringern und die Zuverlässigkeit erhöht wird. Das Endresultat ist ein sehr komplexes, relativ großes, vielschichtiges Keramiksubstrat, in dem sich eine komplizierte interne « Verdrahtung » befindet, und welches in der Lage ist, eine große Anzahl von Halbleiterchips aufzunehmen.

Solche vielschichtigen Keramiksubstrate erfordern relativ komplexe Metallmuster einerseits auf der Oberseite des Substrats, um die Verbindungen zu den Halbleiterchips herzustellen und um Anschlußleitungen zur Durchführung technischer Änderungen bereitzustellen, und andererseits auf der Unterseite des Substrats, um Verbindungen nach außen und Verbindungen anderer Art zu machen. Wenn das grüne Keramiksubstrat gesintert wird, findet normalerweise eine Schrumpfung um 17 bis 20 % statt. Häufig ist die Schrumpfung über das Substrat nicht einheitlich. Da das Substrat relativ groß ist, und die Dimensionen des Metallmusters recht klein sind, ist es schwierig und häufig unmöglich, eine Maske zu produzieren, welche 17 bis 20 % kleiner als das ursprüngliche Substrat ist und welche in allen Bereichen mit dem Metallmuster, welches auf das Substrat vor dem Sintern aufgebracht worden ist, übereinstimmt. Solch eine Maske ist notwendig, um zusätzliche Metallschichten unter Anwendung üblicher Maskierungsverfahren aufzubringen. Wie schon gesagt, wird das erste Metall auf das Substrat vor dem Sintern aufgebracht. Dazu wird eine Paste, welche ein hitzebeständiges Metall enthält, auf die Oberfläche mittels Siebdruck aufgebracht. Nach dem Sintern muß das hitzebeständige Metall mit anderen Metallen, wie z.B. Nickel, Chrom, Gold usw. bedeckt werden, um auf bequeme Art und Weise, beispielsweise durch Löten, Verbindungen zu Halbleiterchips, zu mittels Thermokompression gebundenen Drähten und zu Eingabe- und Ausgabestiften herzustellen. Häufig können solche aufgedruckten Schichten aus hitzebeständigen Metallen mittels stromlosen Plattierens mit dünnen Metallschichten bedeckt werden, wozu keine Maske erforderlich ist. Jedoch sind solche Bedeckungen im allgemeinen dünn und können Verunreinigungen, wie z.B. Phosphor enthalten, welche in nachfolgenden Operationen, in welchen Lötverbindungen hergestellt werden, unerwünscht sein können. Metallschichten können auch durch Elektroplattieren aufgebracht werden. Jedoch ist dazu ein elektrischer Kontakt zu jedem Bereich, auf welchen Metall abgeschieden werden soll, notwendig. Diese Kontakte sind nicht immer herstellbar, da Leiterzüge, welche mit Metall bedeckt werden sollen, solche sein können, welche potentialmäßig nicht festgelegt sind (floating) und deshalb keine Verbindung nach außen haben.

Es ist die Aufgabe der Erfindung, ein einfaches Verfahren zum Aufbringen von, unter Umständen auch relativ dicken, Metallbelägen auf dielektrische Substrate teilweise abdeckende Metallmuster anzugeben, bei dem sichergestellt ist, daß das Metallmuster, aber nicht das Substrat, mit Metall bedeckt wird.

Diese Aufgabe wird mit einem Verfahren der eingangs genannten Art mit den Merkmalen des kennzeichnenden Teils des Anspruchs 1 gelöst.

Die mittels des erfindungsgemäßen Verfahrens hergestellte Maske berücksichtigt — im Gegensatz zu einer auf fotolithographischem Weg erzeugten Maske — automatisch die beim Sintern des Substrats eintretende Schrumpfung. Mit dem erfindungsgemäßen Verfahren ist es deshalb auch dann, wenn die Schrumpfung des Substrats uneinheitlich ist, möglich, Metallbeläge aufzubringen, welche die Metallmuster exakt abdecken. Das erfindungsgemäße Verfahren ist auch nicht wie das stromlose Plattieren auf das Aufbringen von sehr dünnen Metallbelägen beschränkt. Außerdem hat man bei dem erfindungsgemäßen Verfahren nicht wie beim Elektroplattieren das Problem, daß alle Bereiche des Metallmusters mit von außen zugänglichen Anschlußpunkten verbunden sein müssen.

Es ist vorteilhaft, wenn als Material für die Maske ein Gemisch aus LiCl und KCl verwendet wird. Dieses Gemisch greift das Substratmaterial und das Metallmuster nicht an und ist in Wasser löslich.

Es ist vorteilhaft, wenn das Material für die Maske, um es zum Fließen zu bringen und danach zu härten, über seinen Schmelzpunkt erhitzt und danach unter seinen Schmelzpunkt abgekühlt wird und/oder mit Losungsmittel vermischt und danach das Lösungsmittel ausgetrieben wird. Wenn diese beiden Ausführungsformen des erfindungsgemäßen Verfahrens nacheinander durchgeführt werden, erhält man eine besonders gleichmäßige Maskenschicht. Beispielsweise lassen sich diese Ausführungsformen des erfindungsgemäßen Verfahrens mit einem eutektischen Gemisch aus LiCl und KCl durchführen, wobei man, um das Material zum Fließen zu bringen, so vorgehen kann, daß man auf ungefähr 600 °C erhitzt und anschließend auf Raumtemperatur abkühlt und/oder indem man das Gemisch, welches aufgrund seines LiCl-Gehalts hygroskopisch ist, einfach der Luftfeuchtigkeit aussetzt, wodurch es, wenn es genügend Wasser aufgenommen hat, zu fließen beginnt, und zum Härten das Wasser durch Trocknen wieder entfernt.

Es ist günstig, wenn so viel Maskenmaterial auf das Substrat aufgebracht wird, daß die beim Fließenlassen und Härten entstehende Maskenschicht dicker als das Metallmuster ist. Dadurch ist sichergestellt, daß, wenn das Maskenmaterial aufgelöst werden soll, das Lösungsmittel die ganzflächig aufgebrachte Metallschicht durchdringen und zum Maskenmaterial gelangen kann.

Weitere vorteilhafte Ausgestaltungen der Erfindung ergeben sich aus den Unteransprüchen.

Die Erfindung wird anhand von durch Zeichnungen erläuterten Ausführungsbeispielen beschrieben.

Es zeigen :

Figur 1 in einem Flußdiagramm die aufeinanderfolgenden Verfahrensschritte einer Ausführungsform des erfindungsgemäßen Verfahrens und die

Figuren 2 bis 5 Querschnittsdarstellungen eines Ausschnitts einer Struktur in verschiedenen Stadien der Herstellung gemäß dem erfindungsgemäßen Verfahren.

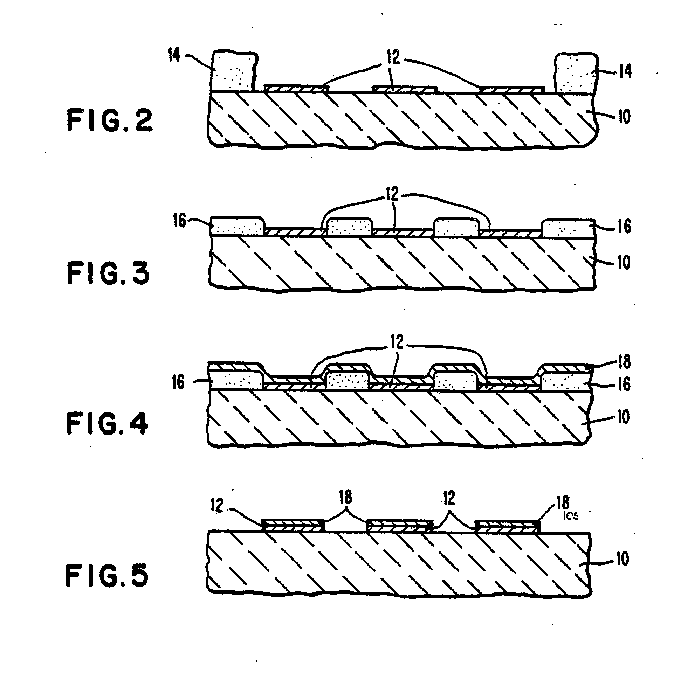

Die Figur 2 zeigt ein gebranntes Keramiksubstrat 10, welches beispielsweise ein vielschichtiges Keramiksubstrat sein kann, welches gemäß dem im US-Patent 3 518 756 beschriebenen Verfahren hergestellt werden kann. Obwohl in den Figuren 2 bis 5 Querschnitte durch ein solches mehrschichtiges Substrat dargestellt sind, ist die Metallurgie zwischen der Keramikschichten in den Figuren nicht gezeigt, da sie für das erfindungsgemäße Verfahren keine Bedeutung haben Es sei jedoch klargestellt, daß das Substrat 10 kein vielschichtiges Keramiksubstrat sein muß, sondern auch aus einem Stück bestehen kann, auf dem die gesamte Metallurgie auf der Oberfläche aufgebracht ist. Normalerweise besteht das Substrat aus Aluminiumoxid oder Aluminiumoxid und anderen Materialien oder aus einem Keramik-Glasmaterial, welches bei einer besonders niedrigen Temperatur gebrannt werden kann. Einzelheiten sind im US-Patent 3 540 894 beschrieben. Auf der Oberfläche des Substrats 10 sind Metallbereiche 12 abgebildet, welche normalerweise aus einem hitzebeständigen Metall bestehen, welches vor dem Sintern des Substrats 10 aufgebracht worden ist. Wenn es erwünscht ist, kann die Metallschicht 12 mit einer nicht gezeigten metallischen Oberflächenschicht versehen sein, welche mittels stromlosen Elektroplattierens, wie es beispielsweise im IBM Technical Disclosure Bulletin, Band 19, NR. 3, August 1976, Seite 929 beschrieben ist, aufgebracht wird.

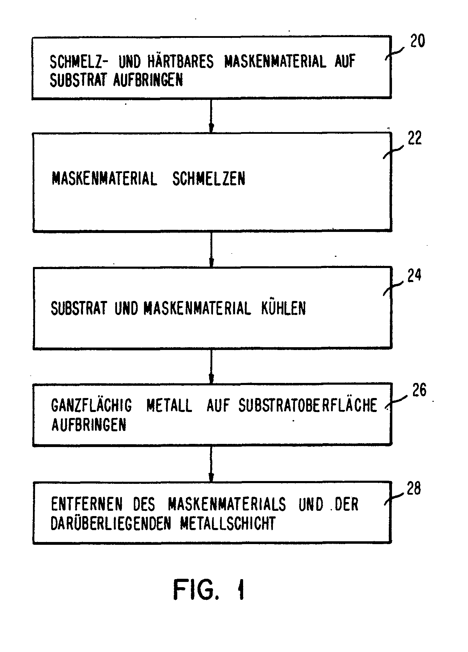

Im ersten Verfahrensschritt, bei dem es sich um den Schritt 20 in der Figur 1 handelt, wird ein schmelz- und härtbares Maskenmaterial 14 aufgebracht. Das Maskenmaterial 14 kann auf der Oberfläche des Substrats 10 mittels irgendeiner geeigneten Technik aufgebracht werden. Beispielsweise kann das Maskenmaterial 14 auf der Oberfläche in kleinen voneinander getrennten Mengen verteilt werden, als Paste durch ein Sieb auf die keramischen Bereiche der Oberfläche grob aufgedruckt werden, oder wird das Material 14 auf der Oberfläche zum Schmelzen und Zerfließen gebracht. Das Material 14 kann auf der oberen Oberfläche des Substrats 10 überall außer auf den Metallbereichen 12 aufgebracht werden. Das Maskenmaterial 14 kann irgendein geeignetes Material sein, welches die keramischen Oberflächenbereiche des Substrats 10 benetzt, wobei der Kontaktwinkel im Bereich um 0 °C liegt, aber sich nicht über die Oberfläche der Metallbereiche 12 ausbreitet, wobei der zugehörige Kontaktwinkel zwischen 60 und 180° liegt. Die Metallbereiche 12 sind also weniger mit dem Material 14 benetzbar als die nicht vom Metall bedeckten Keramikbereiche des Substrats 10. Darüber hinaus muß der Schmelzpunkt des Maskenmaterials 14 unterhalb des Schmelzpunktes des die Bereiche 12 bildenden Metalls liegen. Außerdem darf das Material 14 weder die Keramikoberfläche des Substrats 10 noch das die Bereiche 12 bildende Metall angreifen. Darüber hinaus muß das Material 14 leicht in einem Lösungsmittel löslich sein, welches seinerseits nicht das Substrat oder das Metall angreift. Normalerweise dienen die Metallbereiche 12 als Kontakte zur der inneren Verdrahtung im Substrat 10. Allerdings können sie auch als Verdrahtung zwischen Bauteilen und Anschlüssen nach außen auf der Oberfläche des Substrats dienen. Ein bevorzugtes Material 14 ist eine eutektische Mischung aus LiCl und KCl, welche 41,5 Mol-% LiCl enthält und einen Schmelzpunkt von ungefähr 350 °C hat. Eine eutektische Mischung wird bevorzugt, weil deren Schmelzpunkt niedriger ist als der von nichteutektischen Mischungen. Es können jedoch auch nichteutektische Mischungen von LiCl und KCl verwendet werden, sofern der Schmelzpunkt nicht so hoch ist, daß das Substrat oder das Metall bei der dann anzuwendenden Temperatur beschädigt wird. Jedes andere geeignete Material 14, welches die oben erwähnten Eigenschaften hat, kann auch benutzt werden.

Wie in der Figur 3 gezeigt ist, wird das Substrat, auf welches das Material 14 aufgebracht ist, auf eine Temperatur erhitzt, welche ausreicht, um das Material 14 zu schmelzen. Wenn das Maskenmaterial, wie im Schritt 22 der Figur 1 angegeben ist, geschmolzen ist, wird das Material 14 über die Oberfläche des keramischen Substrats 10 neuverteilt, wobei es die keramischen Bereiche des Substrats, welche benetzbar sind, bedeckt und dabei die Schicht 16 bildet, während die nicht benetzbaren Metallbereiche 12 freibleiben. Wenn das Substrat 10 unter den Schmelzpunkt des Materials 14 abgekühlt wird, verfestigt sich — wie es im Schritt 24 in der Figur 1 angegeben ist — das Material 14. Die verfestigte Schicht 16 kann dann als Maskierungsschicht benutzt werden. Die Verteilung des Materials 14 wird auf diese Weise ohne den Einsatz von Masken bewerkstelligt. Der übliche Einsatz von Masken wäre schwierig, wenn nicht unmöglich, da man mit dem Problem konfrontiert ist, die Maske zu einem Substrat ausrichten zu müssen, das die Tendenz hat, ungleichmäßig zu schrumpfen. Die Dicke der Schicht 16 aus dem Material 14 ist unkritisch. Bevorzugt ist die Schicht dicker als die Metallbereiche 12. Besonders günstig ist es, wenn die Dicke der Schicht aus dem Material 14 wenigstens um 2 µm dicker ist als die Metallbereich 12. Die Dicke der Schicht 16 wird bestimmt durch die Menge an Material 14, welche auf das Substrat 10 gebracht worden ist und durch die Gesamtfläche der mit dem Material 14 benetzbaren Substratbereiche.

Wie die Figur 4 zeigt, wird dann eine Metallschicht 18 auf der Oberfläche des Substrats 10 abgeschieden. Dieser Verfahrensschritt ist in der Figur 1 mit der Nummer 26 bezeichnet. Die Schicht aus dem Metall 18 kann mit irgendeiner geeigneten Methode, wie dem Aufdampfen, dem Aufbringen mittels Kathodenzerstäubung usw. aufgebracht werden. Die Dicke der Schicht 18 ist nicht kritisch, bevorzugt ist sie aber nicht dicker als die Dickendifferenz zwischen der Maskierungsschicht 16 und den Metallbereichen 12. Das Metall, aus welchem die Schicht 18 besteht, kann irgendein geeignetes Metall wie z.B. Nickel, Gold, Chrom, Blei, Bleizinnmischungen oder ein ähnliches Metall sein.

Die Maskierungsschicht 16 aus dem härtbaren Material wird — wie im Schritt 28 in der Figur 1 angegeben — in einem geeigneten Lösungsmittel aufgelöst und damit von dem Substrat 10 entfernt. Die Metallschicht 18 wird, soweit sie auf der Schicht 16 aufgelegen hat, dabei auch entfernt. Das Ergebnis dieses Verfahrensschritts zeigt die Figur 5.

Wenn erwünscht, können zusätzliche Metallschichten auf dem Substrat 10 aufgebracht werden, indem der eben beschriebene Prozeß wiederholt wird, oder indem mehrere nicht zu dicke Metallschichten bei dem Verfahrensschritt, welcher in der Figur 1 mit der Nummer 26 bezeichnet ist, aufgebracht werden, wobei dann über den Metallbereichen 12 eine aus mehreren Metallschichten bestehende Struktur erzeugt wird.

Die folgenden Ausführungsbeispiele sollen das erfindungsgemäße Verfahren weiter verdeutlichen, es sei aber klargestellt, daß die Anwendung des erfindungsgemäßen Verfahrens nicht auf diese Ausführungsbeispiele beschränkt ist.

Beispiel I

Ein vielschichtiges Keramiksubstrat wurde aus Aluminiumoxid-Keramik-Material hergestellt. Auf das Substrat wurde auf die obere Oberfläche ein Leitermuster und auf die untere Oberfläche ein Muster von Anschlüssen nach außen aus Molybdän hergestellt. Die Molybdänmuster auf der oberen und der unteren Oberfläche wurden mittels Siebdrucks unter Verwendung einer Pastenmischung, welche Molybdän und ein Bindemittel enthielt, auf der Oberfläche des grünen Keramiksubstrats vor dem Sintern aufgebracht. Beim Sintern wurde das Bindemittel in der Paste und auch das Bindemittelharz im Substrat weggebrannt. Die Molybdänmuster waren gemessen von der oberen Oberfläche des Substrats ungefähr 5 µm dick. Das gesinterte Substrat wurde zuerst einem Karborundpulver enthaltenden Dampfstrahl und anschließend 45 Sekunden lang einer wässrigen Lösung ausgesetzt, die 215 g $K_3Fe(CN)_6$ und 75 g KOH pro Liter enthielt. Das Substrat wurde dann 12 Minuten lang in eine kochende wässrige KOH-Lösung, welche eine Konzentration von 100 g KOH pro Liter hatte, getaucht. Anschließend wurde das Substrat 10 Sekunden lang in eine wässrige 10 % ige HCl-Lösung getaucht. Die vorangegangenen Schritte waren notwendig, um die Oberfläche des Substrats und der Metallbereiche vollständig zu reinigen. Eine eutektische LiCl/KCl-Mischung,

welche 41,5 Mol-% LiCl und 58,5 Mol-% KCl enthielt, wurde hergestellt. Die Mischung wurde in Form eines Pulvers auf die Keramikbereiche der Oberfläche des gereinigten Vielschichtsubstrats aufgestreut, und das Substrat wurde dann in Formiergas bei einer Temperatur von 600 °C erhitzt, bis das Material geschmolzen war und sich über die Oberfläche ausgebreitet hatte. Das Erhitzen dauerte ungefähr eine halbe Stunde. Die resultierende durchschnittliche Dicke der LiCl/KCl-Schicht lag bei 10 µm. Anschließend wurde eine Goldschicht mit einer Dicke von 1 µm ganzflächig mittels Aufdampfens auf die Oberfläche des Substrats aufgebracht und schließlich wurde das Substrat in Leitungswasser gewaschen, was die Entfernung der LiCl/KCl-Schicht und des auf ihr liegenden Goldes bewirkte. Eine Untersuchung des Substrats zeigte, daß eine einheitliche Goldschicht nur auf den Molybdänbereichen abgeschieden worden war.

Beispiel II

Ein Vielschichtsubstrat, wie es im Beispiel I beschrieben worden ist, wurde in ein Bad zur stromlosen Vernickelung getaucht, wobei sich eine 3 µm dicke Nickelschicht auf der Oberfläche der Molybdänbereiche abschied. Das Substrat wurde dann auf 680 °C erhitzt, um das Nickel in das darunterliegende Molybdän einzudiffundieren. Nachdem das Substrat gereinigt worden war, wurde, wie oben beschrieben, eine Schicht aus LiCl und KCl auf das Substrat aufgebracht, geschmolzen und dann abgekühlt. Anschließend wurde eine Schicht, welche 95 % Blei und 5 % Zinn enthielt, auf die Oberfläche in einer Dicke von 3 µm aufgedampft. Die LiCl/KCl-Schicht wurde wieder in Leitungswasser gelöst und dabei zusammen mit den auf ihr liegenden Bereichen der Blei-Zinn-Schicht entfernt. Das Verfahrensergebnis war eine Metallbereichskonfiguration auf dem Substrat, auf deren 3 µm dicken Blei/Zinn-Schicht Halbleiterchips aufgelötet werden konnten.

Beispiel III

Ein Vielschichtsubstrat wurde, wie in Beispiel I beschrieben, hergestellt und gesintert.

Das Substrat wurde in eine gesättigte Lösung von NAF.HF in Wasser 10 Minuten lang bei Raumtemperatur getaucht, anschließend in deionisiertem Wasser gewaschen und dann in einem trockenen Stickstoffstrom getrocknet.

Aus einer Mischung von gleichen Gewichtsteilen Lithiumchlorid und Kaliumchlorid und einer kleinen Menge Wasser wurde ein dicker Brei hergestellt. Der Brei wurde auf die Keramikbereiche zwischen den Molybdängebieten mittels Siebdruck aufgebracht. Das Substrat wurde langsam in Formiergas auf ungefähr 600 °C aufgeheizt, damit zuerst das Wasser verdampfen konnte und anschließend die LiCl/KCl-Mischung schmelzen und sich dann über die gesamte freiliegende Keramikoberfläche zwischen den Molybdänbereichen ausbreiten konnte.

Nach dem Abkühlen wurde das Substrat zwei Stunden lang in Luft bei Raumtemperatur gelagert. Da das Lithiumchlorid hygroskopisch ist, wurde dabei Feuchtigkeit aus der Luft angezogen, wobei sich eine Lösung der Salze in Wasser bildete. Das Substrat wurde dann in einen Exsikkator gelegt, welcher als Trockensubstanz Schwefelsäure enthielt. Beim Trocknen wurde das Wasser auf der LiCl/KCl/Lösung entfernt und zurück blieb eine Schicht der Salze auf der Keramikoberfläche, welche einheitlicher war als zuvor. Auf das Substrat wurde ganzflächig eine Goldschicht aufgedampft und anschließend, wie im Beispiel I beschrieben, von den Keramikbereichen zwischen den Molybdänbereichen abgehoben.

**Ansprüche**

1. Verfahren zum Aufbringen von Metall (18) auf Metallmuster (12), welche auf einem dielektrischen Substrat (10) aufliegen, dadurch gekennzeichnet, daß auf nicht mit dem Metallmuster (12) abgedeckte Oberflächenbereiche des Substrats ein Material (14), welches zum Fließen gebracht werden kann und härtbar ist, und welches das dielektrische Material (10), aber nicht das Metallmuster (12) benetzt, aufgebracht wird, daß zur Bildung einer, das Metallmuster aussparenden Maskenschicht (16) das Material (14) zum Fließen gebracht und danach gehärtet wird und daß anschließend — in an sich bekannter Weise — ganzflächig eine Metallschicht (18) aufgebracht wird und dann die Maskenschicht (16) mit einem Lösungsmittel, und dabei gleichzeitig die auf ihr liegenden Bereiche der Metallschicht (18) entfernt werden.

2. Verfahren nach Anspruch 1, dadurch gekennzeichnet, daß ein dielektrisches Substrat (10) aus einem keramischen Material verwendet wird.

3. Verfahren nach Anspruch 2, dadurch gekennzeichnet, daß ein dielektrisches Substrat (10) verwendet wird, welches aus einem keramischen Glasmaterial oder aus Aluminiumoxid besteht, oder dieses Material wenigstens enthält.

4. Verfahren nach einem oder mehreren der Ansprüche 1 bis 3, dadurch gekennzeichnet, daß als Material (14) ein Gemisch aus LiCl und KCl verwendet wird.

5. Verfahren nach Anspruch 4, dadurch gekennzeichnet, daß eine eutektische Mischung aus LiCl und KCl verwendet wird.

6. Verfahren nach einem oder mehreren der Ansprüche 1 bis 5, dadurch gekennzeichnet, daß das Material (14), um es zum Fließen zu bringen und danach zu härten, über seinen Schmelzpunkt erhitzt und danach unter seinen Schmelzpunkt abgekühlt wird und/oder mit Lösungsmittel vermischt und danach das Lösungsmittel ausgetrieben wird.

7. Verfahren nach Anspruch 6, dadurch gekennzeichnet, daß bei Verwendung des LiCl/KCl-

Gemisches auf ungefähr 600 °C erhitzt wird und nach dem Fließen wieder auf Raumtemperatur abgekühlt wird und/oder das Gemisch der Luftfeuchtigkeit ausgesetzt und nach dem Zerfließen des Gemisches das Wasser durch Trocknen entfernt wird.

8. Verfahren nach einem oder mehreren der Ansprüche 1 bis 7, dadurch gekennzeichnet, daß die Maskenschicht (16) dicker als das Metallmuster (12) gemacht wird.

9. Verfahren nach Anspruch 8, dadurch gekennzeichnet, daß die Maskenschicht (16) mindestens 2 μm dicker als das Metallmuster (12) gemacht wird.

## Claims

1. A process for depositing metal (18) over a metal pattern (12) supported on a dielectric substrate (10), characterized in that a material (14), which can be made to flow and is hardenable and which wets the dielectric material (10) but not the metal pattern (12), is deposited over the surface areas of the substrate not covered by the metal pattern (12), that for forming a masking layer (16), without covering the metal pattern, the material (14) is caused to flow and then hardened, and that subsequently a blanket metal layer (18) is deposited in a manner known per se, and the masking layer (16) is removed with a solvent, simultaneously removing the overlying portions of the metal layer (18).

2. The method according to claim 1, characterized in that a dielectric substrate (10) of ceramic material is used.

3. The method according to claim 2, characterized in that a dielectric substrate (10) is used which consists of a ceramic glass material or of aluminium oxide or at least contains said material.

4. The method according to one or more of claims 1 to 3, characterized in that the material (14) is a mixture of LiCl and KCl.

5. The method according to claim 4, characterized in that a eutectic mixture of LiCl and KCl is used.

6. The method according to one or more of claims 1 to 5, characterized in that the material (14), for causing it to flow and subsequently be hardened, is heated above its melting point and then cooled below its melting point and/or is mixed with solvent, subsequently driving out said solvent.

7. The method according to claim 6, characterized in that when the LiCl/KCl mixture is used, heating is effected to about 600° and after flowing, cooling is effected to room temperature and/or the mixture is exposed to the humidity of the air, removing the water by drying after the mixture has deliquesced.

8. The method according to one or more of claims 1 to 7, characterized in that the masking layer (16) is made to be thicker than the metal pattern (12).

9. The method according to claim 8, characterized in that the masking layer (16) is made to be at least 2 μm thicker than the metal pattern (12).

## Revendications

1. Procédé pour déposer du métal (18) sur des configurations métalliques (12) se trouvant sur un substrat diélectrique (10), caractérisé en ce qu'on dépose, sur des régions de surface du substrat non recouvertes de la configuration métallique (12), un matériau (14) pouvant être fluidifié et durci et qui humecte le matériau diélectrique (10) mais non la configuration métallique (12), en ce qu'on fluidifie et durcit ensuite le matériau (14) pour former une couche masquante (16) exposant la configuration métallique, et en ce qu'on dépose ensuite, d'une manière bien connue, une couche métallique (18) recouvrant l'ensemble et qu'on élimine la couche masquante (16) à l'aide d'un solvant, les régions superposées de la couche métallique (18) étant simultanément enlevées.

2. Procédé selon la revendication 1, caractérisé en ce que le substrat diélectrique (10) est constitué par un matériau en céramique.

3. Procédé selon la revendication 2, caractérisé en ce que le substrat diélectrique (10) est constitué par un matériau de verre en céramique ou par un oxyde d'aluminium ou contient au moins dudit matériau.

4. Procédé selon l'une quelconque ou plusieurs des revendications 1 à 3, caractérisé en ce qu'on utilise comme matériau (14) un mélange de LiCl et KCl.

5. Procédé selon la revendication 4, caractérisé en ce qu'on utilise un mélange eutectique de LiCl et de KCl.

6. Procédé selon l'une quelconque ou plusieurs des revendications 1 à 5, caractérisé en ce que dans le but de fluidifier et ensuite de durcir le matériau (14), ledit matériau est chauffé au-dessus de son point de fusion et ensuite refroidi en dessous de son point de fusion et/ou est mélangé avec un solvant, ce solvant étant ensuite éliminé.

7. Procédé selon la revendication 6, caractérisé en ce que, lors de l'utilisation du mélange LiCl/KCl, on chauffe celui-ci à une température d'environ 600 °C et, après le fluage, on le refroidit à la température ambiante et/ou on expose le mélange à l'humidité de l'air et on élimine l'eau par séchage après le fluage.

8. Procédé selon l'une quelconque ou plusieurs des revendications 1 à 7, caractérisé en ce que la couche masquante (16) est rendue plus épaisse que la configuration métallique (12).

9. Procédé selon la revendication 8, caractérisé en ce que la couche masquante (16) est plus épaisse, d'au moins 2 μm, que la configuration métallique (12).

```
┌─────────────────────────────────────────────┐ 20
│ SCHMELZ- UND HÄRTBARES MASKENMATERIAL AUF    │
│ SUBSTRAT AUFBRINGEN                          │
└─────────────────────────────────────────────┘
                      │
                      ▼
┌─────────────────────────────────────────────┐ 22
│                                              │
│ MASKENMATERIAL  SCHMELZEN                    │
│                                              │
└─────────────────────────────────────────────┘
                      │
                      ▼
┌─────────────────────────────────────────────┐ 24
│                                              │
│ SUBSTRAT UND MASKENMATERIAL KÜHLEN           │
│                                              │
└─────────────────────────────────────────────┘
                      │
                      ▼
┌─────────────────────────────────────────────┐ 26
│ GANZFLÄCHIG  METALL  AUF SUBSTRATOBERFLÄCHE  │
│ AUFBRINGEN                                   │
└─────────────────────────────────────────────┘
                      │
                      ▼
┌─────────────────────────────────────────────┐ 28
│ ENTFERNEN DES MASKENMATERIALS UND .DER       │
│ DARÜBERLIEGENDEN METALLSCHICHT               │
└─────────────────────────────────────────────┘
```

## FIG. 1

**FIG.2**

14     12     14

10

**FIG.3**

12

16     16

10

**FIG.4**

12

18

16     16

10

**FIG.5**

12    18    12    18

10